# EUROPEAN PATENT SPECIFICATION

(11) **EP 0 790 132 B1**
(45) Date of publication and mention of the grant of the patent: **10.05.2000**
(21) Application number: 97102014.4
(22) Date of filing: 06.02.1997
(51) Int. Cl.: B41J 2/45

(54) **Optical print head**
Optischer Druckkopf
Tête d'impression optique

(30) Priority: 13.02.1996 JP 2537696; 27.09.1996 JP 25650196
(43) Date of publication of application: 20.08.1997
(73) Proprietor: Oki Data Corporation, Tokyo 108-8551 (JP)
(72) Inventor: Tsukagoshi, Hisashi c/o Oki Data Corporation, Tokyo 108 (JP); Teshima, Minoru c/o Oki Data Corporation, Tokyo 108 (JP); Nakajima, Norio c/o Oki Data Corporation, Tokyo 108 (JP)
(74) Representative: Kirschner, Klaus Dieter, Dipl.-Phys.

(56) References cited:
- EP-A- 0 504 575
- EP-A- 0 601 485
- US-A- 4 951 064
- US-A- 5 179 396
- US-A- 5 357 123
- PATENT ABSTRACTS OF JAPAN vol. 011, no. 014 (M-553), 14 January 1987 & JP 61 189965 A (OKI ELECTRIC IND CO LTD), 23 August 1986,

## Description

### BACKGROUND OF THE INVENTION

### TECHNICAL FIELD OF THE INVENTION

The present invention relates to an optical print head used in electrophotographic recording apparatuses such as an electrophotographic printer and a copying machine, and more particularly to the construction of the optical print head in which light illuminates a latent image-bearing body to form an electrostatic latent image therein.

### DESCRIPTION OF RELATED ART

Electrophotographic recording apparatuses including electrophotographic printers incorporate an optical head, charger, developer, transferring device, and cleaner, disposed around a photosensitive drum that bears a latent image therein. The optical print head incorporates a light source such as lasers, LEDs, and liquid crystal devices. For example, with an optical print head using LEDs, LED array chips are arranged in line on a printed circuit board, each array chip having a plurality of LEDs fabricated therein. Driver ICs which drive the LED array chips are also arranged in line parallel to the LED array chips. Electrical connections between the LED array chips and driver ICs are made by wire bonding. The LED array chips emit light in a direction normal to the component side, the light traveling toward a lens array such as SELFOC lens array. The lens array gathers the light emitted from the LED chips and directs the gathered light to illuminate the photosensitive drum, thereby forming a latent image on the photosensitive drum.

The aforementioned optical print head is of the construction where the LED array chips emit light in a direction normal to the component side of the circuit board. This construction requires a considerable width which occupies a relatively large space when mounted around the photosensitive drum. Therefore, the photosensitive drum should have a large diameter so that the optical print head, can be comfortably mounted together with other components around the photosensitive drum. A larger diameter of the photosensitive drum is an obstacle to miniaturizing of the apparatus.

JP-A-6 118 965 discloses an optical print head for use in an electrographic printer.

### SUMMARY OF THE INVENTION

An object of the present invention is to provide an optical print head for use in an electrophotographic printer which occupies a minimum space in the direction of circumference of the photosensitive drum.

The object of the invention is achieved by an optical print head having a light-emitting array chip (2), driver IC (4) that drives the light-emitting array chip (2), lens array (10), and circuit board (1) to which the light-emitting array chip (2) and driver IC are mounted. The light-emitting array chip (2) has light emitting elements (43) therein aligned in line. The driver IC (4) electrically is connected to the light-emitting array chip (2), and electrically drives the light-emitting array chip (2) to emit light. The lens array (10) gathers the light emitted from the light-emitting elements (43) and emanates the gathered light onto the photosensitive drum. The lens array (10) has a focal point and is positioned relative to the light-emitting array chip (2) so that the focal point of the lens array (10) is on the light-emitting elements (43). The circuit board (1, 75) has a surface on which the light-emitting array chip (2) and the driver IC (4) are mounted. The circuit board (1, 75) supports the light-emitting array chip (2) so that the light-emitting elements (43) emit the light in a direction parallel to the surface of the circuit board (1, 75).

Further scope of applicability of the present invention will become apparent from the detailed description given hereinafter. However, it should be understood that the detailed description and specific examples, while indicating preferred embodiments of the invention, are given by way of illustration only, since various changes and modifications within the scope of the invention as defined in the appended claims will become apparent to those skilled in the art from this detailed description.

### BRIEF DESCRIPTION OF THE DRAWINGS

The present invention will become more fully understood from the detailed description given hereinbelow and the accompanying drawings which are given by way of illustration only, and thus are not limitative of the present invention, and wherein:
Fig. 1 is a cross-sectional view of an LED print head of a first embodiment;
Fig. 2 is a perspective view showing an LED array unit of the first embodiment;
Fig. 3 illustrates a general construction of an electrophotographic printer of the first embodiment;
Fig. 4 is a cross-sectional view of a first modification of the first embodiment;
Fig. 5 is a cross-sectional view of a second modification of the first embodiment;
Fig. 6 is a cross-sectional vie of a third modification of the first embodiment;
Fig. 7 is a cross-sectional view of a fourth modification of the first embodiment;
Fig. 8 is a cross-sectional view of a fifth modification of the first embodiment;
Fig. 9 is a cross-sectional view of a sixth modification of the first embodiment;
Fig. 10 is a cross-sectional view of a seventh modification of the first embodiment;
Fig. 11A is a perspective view showing the base;
Fig. 11B is a perspective view showing the supporting member of the seventh modification;
Fig. 12 illustrates a modification of the supporting member in Fig. 11B;
Fig. 13 is a perspective view of an LED array unit of a second embodiment;
Fig. 14 is a front view of Fig. 13 as seen in a direction shown by arrow A;
Fig. 15 is a side view of Fig. 13 taken along lines XV-XV;
Fig. 16 is a front view of an LED array chip which is a modification of the second embodiment;
Fig. 17 is a perspective view of a wafer of the modified LED array chip;
Fig. 18 is a cross-sectional view of an LED print head of a third embodiment;
Fig. 19 is a perspective view of the positioning member of the third embodiment;
Fig. 20 is a cross-sectional view of a modified LED print head of the third embodiment;
Fig. 21 is a perspective view of a relevant part of the LED print head 71 of the third embodiment;
Fig. 22 is a cross-sectional view of an LED print head of a fourth embodiment; and
Fig. 23 is a cross-sectional perspective view of a lower supporting member of the fourth embodiment.

### DETAILED DESCRIPTION OF THE INVENTION

### First embodiment

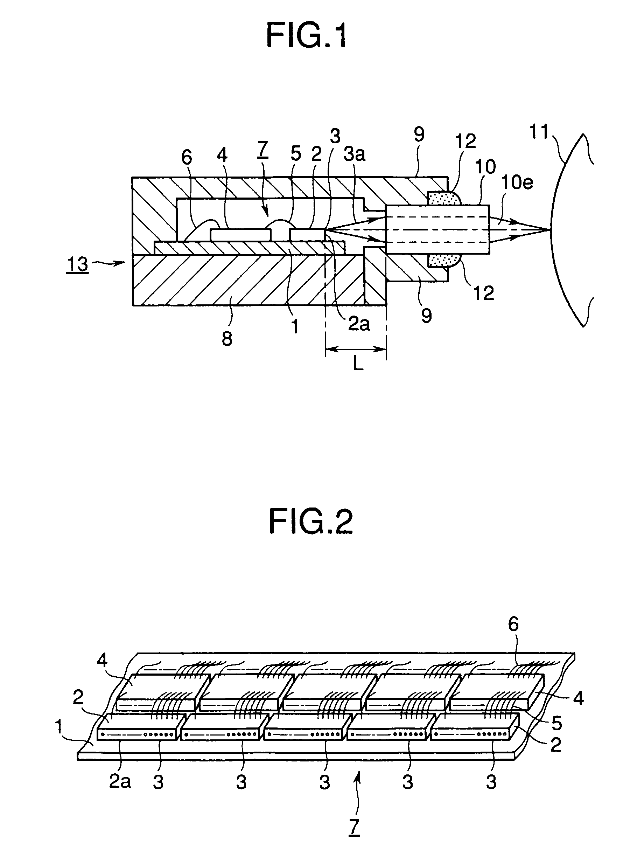

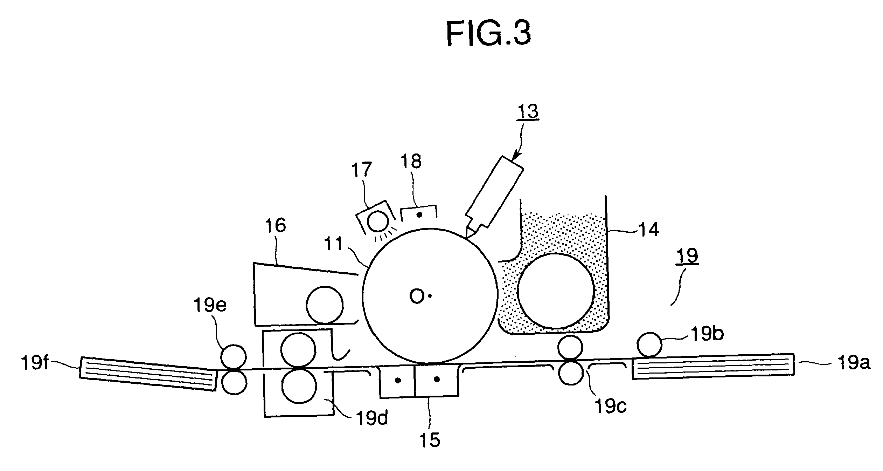

The preferred embodiments of the present invention will be described with reference to the accompanying drawings. Fig. 1 is a cross-sectional view of an optical print head of a first embodiment in the form of an LED print head. Fig. 2 is a perspective view showing an LED array unit 7. Fig. 3 illustrates a general construction of an electrophotographic printer to which the an optical print head of the first embodiment is applicable.

An optical print head according to the present invention is an LED print head for use in an electrophotographic printer.

Referring to Fig. 1 and 2, a plurality of LED (Light Emitting Diode) array chips 2 are mounted in line on a circuit board 1. The LED array chips 2 emit light 3a in a lateral direction of an LED print head 13, from left to right in Fig. 1. The LED array chips 2 have light-emitting elements 3 disposed in its side surface 2a. The light-emitting elements 3 are spaced apart at predetermined intervals in accordance with the intended resolution of the LED print head 13. For example, light-emitting elements 3 are spaced apart 42.3 µm intervals if the resolution is 600 DPI (dot per inch). The number of LED chips 2 is determined by the width of a print medium. For example, about 40 chips are disposed on the circuit board 1. There are as many driver ICs 4 as there are LED array chips 2, each driver IC 4 being electrically connected by bonding wire 5 to a corresponding LED array chip 2 and driving it. The driver ICs 4 are also electrically connected by bonding wires 6 to the pattern traces on the circuit board 1. The circuit board 1, LED array chip 2, and driver IC 4 constitute an LED array unit 7.

The LED array unit 7 is held on a base 8 made of, for example, aluminum, which base 8 serves as a heat sink and provides the overall rigidity of the LED print head. A supporting member 9 covers and holds a lens array 10 in the form of, for example, SELFOC lens array. The supporting member 9 may be made in one piece construction of of any suitable material. The lens array 10 includes an array of optical fibers. The optical fibers each extend in a direction parallel to the surface of the circuit board 1, and gathers the light emitted from the LED array chips 2 to illuminate the surface of a photosensitive drum 11. The lens array 10 is fixedly mounted by an adhesive 12. The supporting member 9 holds the LED array unit 7 and lens array 10 so that the focal point of the lens array 10 is on the light emitting surface of the light emitting element 3 of the LED array chips 2. In other words, the distance L between the lens array 10 and light-emitting elements 3 is equal to the focal length of the lens array 10. The LED print head 13 is of a thin construction extending in the direction of travel of the light 3a as shown in Fig. 1.

Fig. 3 illustrate a general construction of an electrophotographic printer incorporating the optical print head 13 of the first embodiment. Referring to Fig. 3, The photosensitive drum 11 is surrounded by the LED print head 13, a developer 14, transfer device 15, cleaner 16, discharging device 17, and charger 18.

A hopping roller 19b feeds print paper one sheet at a time from a paper cassette 19a into a pair of feeding rollers 19c. Then the paper is transported to the transferring device 15 which transfers a toner image onto the paper. The paper is then fed between a heat rollers 19d for fixing. The paper is then pulled by a pair of discharge rollers 19e into an exit stacker 19f.

The LED print head 13 is oriented so that the optical axis of the emitted light passes through the center O of the photosensitive drum 11. The LED print head 13 of thin construction occupies a minimum space in the circumferential direction of the photosensitive drum 11, lending itself to miniaturizing the photosensitive drum 11, hence a smaller sized electrophotographic printer.

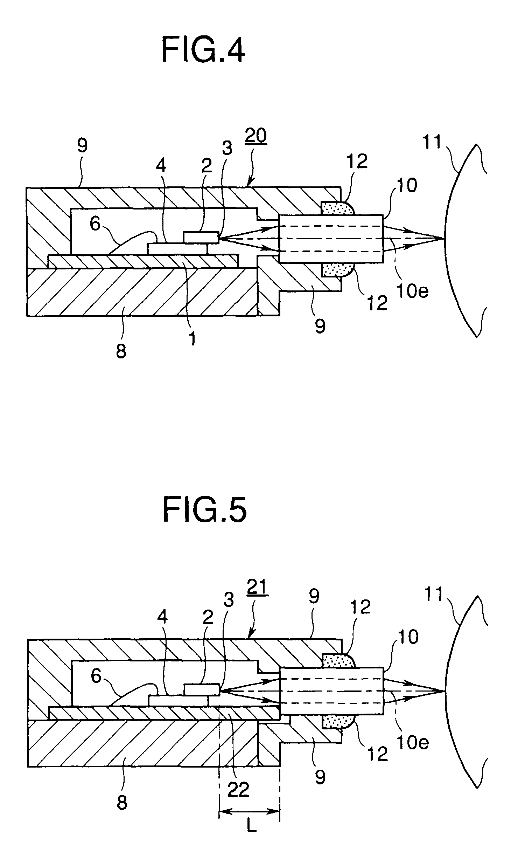

Fig. 4 is a cross-sectional view of a first modification of the first embodiment. Referring to Fig. 4, the LED array chips 2 are mounted on the driver ICs 4. The LED array chips 2 are connected to the corresponding driver ICs 4 so that the electrode pads of each LED array chip 2 are electrically and mechanically connected to the corresponding electrode pads by an anisotropically conductive film.

The first modification provides the same advantages as the first embodiment and eliminates the need for wire bonding between the LED array chips 2 and driver ICs 4, simplifying the manufacture of the optical print head.

Fig. 5 is a cross-sectional view of a second modification of the first embodiment. Referring to Fig. 5, the circuit board 22 is assembled in an abutting relation with the lens array 10. In other words, the position of the lens array 10 relative to the LED array chip 2 is determined by the lateral dimension L of the circuit board 22. The distance L between the lens array 10 and the surface of light emitting elements 3 is selected to be equal to the focal length of the lens array 10.

In the second modification, the position of the lens array 10 relative to the LED array chips 2 can be determined by the lateral dimension L of the circuit board. This eliminates the precision machining of the supporting member 9 which directly affects, in the first embodiment, the position of the lens array 10 relative to the LED array chips 2.

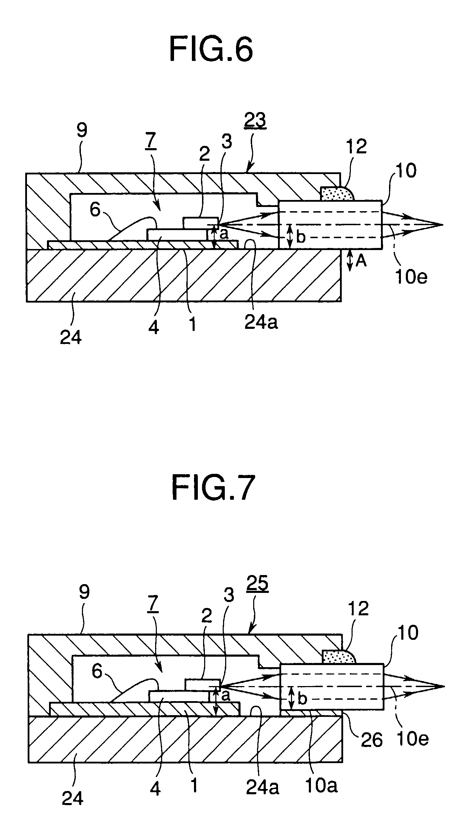

Fig. 6 is a cross-sectional view of a third modification of the first embodiment. Referring to Fig. 6, the LED array unit 7 and the lens array 10 are both mounted on a base 24 so that the positions of optical axes of the LED array chips 2 and lens array 10 are determined with respect to the base 24 in a direction shown by arrow A perpendicular to the optical axes. The base 24 may be made of any suitable material. The LED array unit 7 and lens array 10 are mounted on the same flat surface of the base 24 so that the height a of the light emitting elements 3 is the same as the height b of the optical axis 10e of the lens array 10. The rest of the construction is the same as that of the first embodiment.

In the third embodiment, the base 24 serves as a reference height which is common to the LED array chips 2 and lens array 10, eliminating sources of cumulative dimensional errors resulting from the construction Figs. 1, and 4-5 in which the position of the LED array chips 2 relative to the lens array 10 is determined by a plurality of structural members such as the supporting member 9 and base 8.

Fig. 7 is a cross-sectional view of a fourth modification of the first embodiment. Referring to Fig. 7, the fourth modification differs from the third modification in that a spacer 26 is inserted between the base 24 and the lens array 10. The rest of the construction is the same as that of the third modification.

Mounting the lens array 10 with the spacer 26 inserted between the base 24 and lens array 10 offers an additional degree of freedom in the thickness of the lens array 10 since the thickness of the spacer 26 can be varied in accordance with the thickness of the lens array 10. The spacer is advantageously used to adjust the height of the lens array 10 so that the the optical axis of the lens array is in line with the optical axis of the light-emitting LED array chips.

The spacer 26 may be made of, for example, silicone rubber which offers intimate contact between the lens array 10 and base 24, providing an increased seal from the environment.

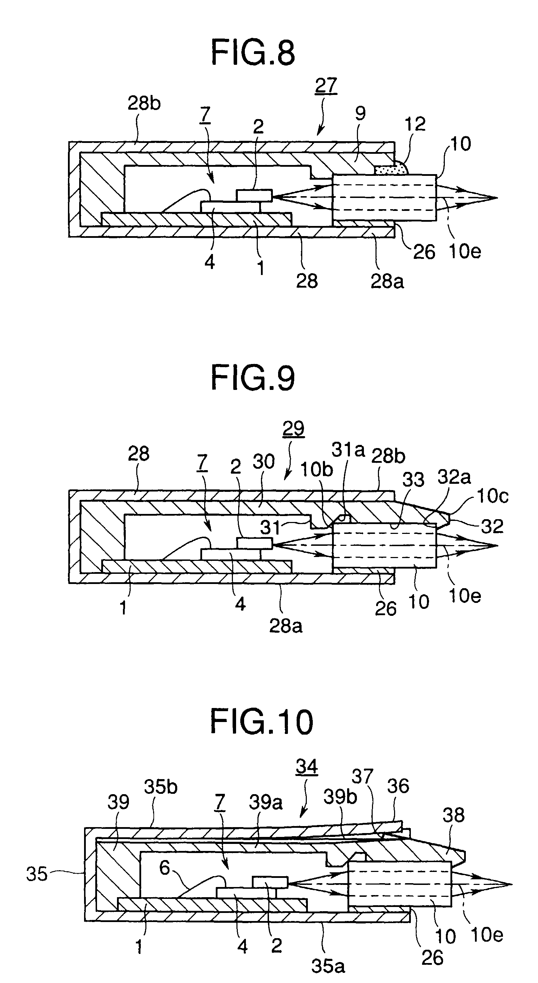

Fig. 8 is a cross-sectional view of a fifth modification. Referring to Fig. 8, a base 28 having a U-shaped cross section includes an upper plate 28b and a lower plate 28a and holds the LED array unit 7, supporting member 9, and lens array 10 between the upper and lower plates 28a and 28b. The base 28 is made of, for example, aluminum or steel. Inserted between the lower plate 28a and the lens array 10 is a spacer 26. The rest of the construction is the same as that of the fourth modification.

Holding the LED array unit 7, supporting member 9, and lens array 10 in a "shell-like construction" of the base 28 having a U-shaped cross section, the fifth embodiment provides a high overall rigidity of the optical print head, lending itself to miniaturizing the LED print head 27.

Fig. 9 is a cross-sectional view of a sixth modification of the first embodiment. Referring to Fig. 9, the sixth modification differs from the fifth modification in that a supporting member 30 is used in place of the supporting member 9. The supporting member 30 has two engaging portions 31 and 32. The engaging portion 31 has a bevel 31a and the engaging portion 32 has a hook 32a. The engaging portion 31 abuts a corner 10b of the lens array 10 and the engaging portion 32 abuts a corner 10c of the lens array 10, thereby holding the lens array 10 between the engaging portions 31 and 32. The base 28 has a lower plate 28a and an upper plate 28b which hold the lens array 10, supporting member 30 and spacer 26 therebetween in a sandwiched manner. When the upper and lower plates 28b and 28a exert forces in such directions as to forcibly sandwich the lens array 10, supporting member 30, and spacer 26 together, the upper and lower plates cause the corner 10b of the lens array 10 to slide on the beveled surface 31a toward the contact surface 33, so that the corner 10c of the lens array 10 is urged against the hook 32a. Thus, the lens array 10 is firmly positioned in the direction of the optical axis 10e thereof, while also being urged against the contact surface 33 of the supporting member 30 to be firmly positioned in the direction perpendicular to the optical axis 10e of the lens array 10.

The need for bonding the lens array 10 by an adhesive is eliminated by the aforementioned construction where the lens array 10 is fixedly mounted in intimate contact with engaging portions 31 and 32. Merely assembling the LED array unit 7 and the supporting member 30 into the base 28 automatically determines th position of the lens array 10, simplifying the assembly of an LED print head.

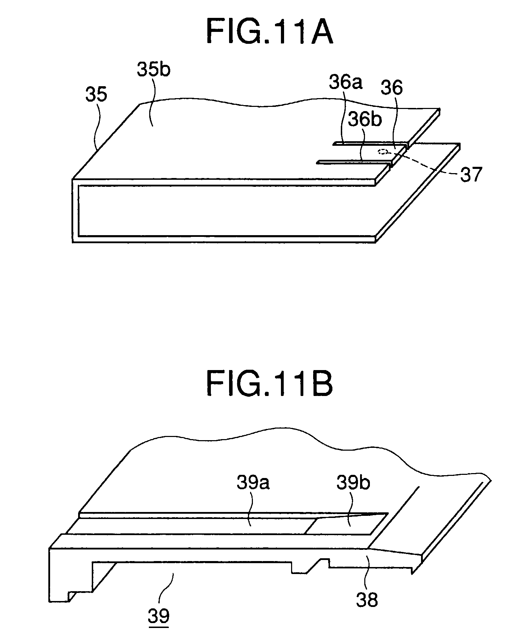

Fig. 10 is a cross-sectional view of a seventh modification and Figs. 11A and 11B are perspective views showing the base and supporting member, respectively. A base 35 having a U-shaped cross section includes an upper plate 35b and a lower plate 35a which extend parallel to each other. The upper plate 35b is formed with two cutouts 36a and 36b that define a spring 36 therein. The spring 36 has a projection 37 projecting inwardly from the inner surface of the spring 36. The spring 36 is yieldably and resiliently deformable in a direction substantially normal to the the upper plate 35b. A supporting member 38 is formed with an I-shaped groove 39 in which when assembling, the projection 37 slidably moves. The projection 37 does not cause the spring 36 to significantly flex when the spring 36 slides on the flat bottom 39a but causes the spring 36 to flex progressively outwardly as the projection 37 climbs up the beveled bottom surface 39b. As the spring 36 flexes outwardly, the spring 36 exerts a larger pressing force which acts on the supporting member 38. The spring 36 may be formed at a plurality of locations in the base 35. The rest of the construction is the same as that of the sixth modification.

The aforementioned construction where the spring 36 urges the supporting member 38, can conveniently absorb dimensional errors of the supporting member 38, lens array 10, and LED array unit 7 if the cumulative error is smaller than a predetermined value upon assembling these structural elements. The construction facilitates the assembly operation of the optical print head and ensures that the lens array 10 is firmly held by the base 35.

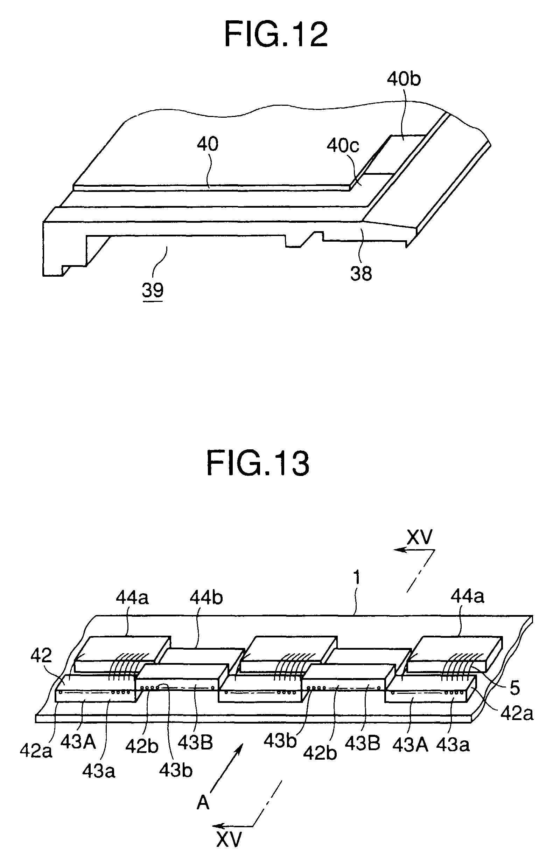

The base 38 may be formed with a generally L-shaped groove 40 as shown in Fig. 12 in place of the I-shaped groove 39. When assembling, the base 35 is fitted to the base 38 so that the projection 37 slides in the groove 40 and then slides laterally to climb a beveled surface 40b, the wall 40c of the L-shaped groove preventing the spring 36 from being pulled out. Then, the base 35 is fastened to the base 38 so that the projection 37 will not climb down the beveled surface 40b. The projection 37 may climb fully the beveled slope 40b and pass onto the flat surface of the base 35 in which case the base 35 is fixed to the base 38 by some parts of the optical print head, not shown.

### Second embodiment

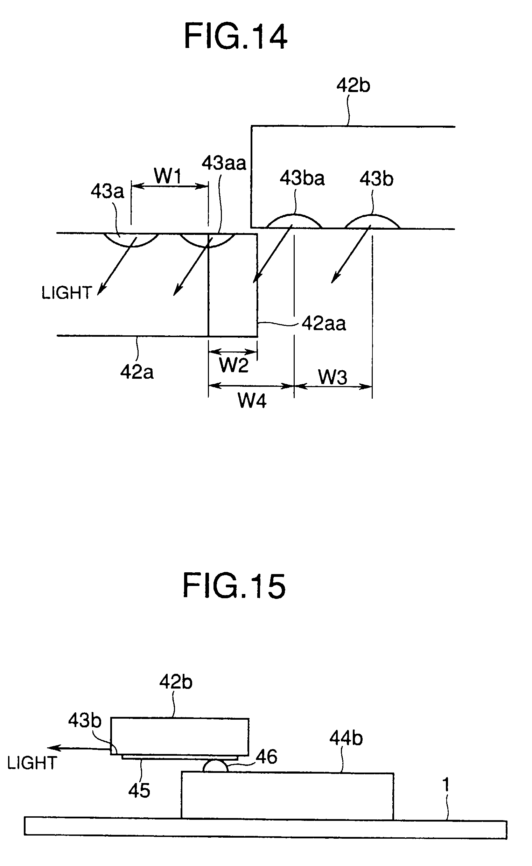

Fig. 13 is a perspective view of an LED array unit of a second embodiment. Fig. 14 is a front view of Fig. 13 as seen in a direction shown by arrow A and Fig. 15 is a side view taken along lines XV-XV. The second embodiment differs from the first embodiment in the arrangement of the LED array chips.

Referring to Fig. 13, an LED array chip 42 includes light-emitting elements 3 disposed in its side surface. The LED array chips 42 are aligned in an upper row and a lower row in such a way that one LED chip 43A is mounted face up in the lower row between the adjacent LED array chips 43B mounted face down in the upper row. The LED array chips 43B in the upper row are held overlapping in part with the adjacent LED array chips 43A in the lower row. The light emitting elements 43a and 43b are offset from the center line of the side surface, so that the light emitting elements 43a and 43b are aligned substantially in line when the upper and lower LED array chips 43A and 43B are assembled on the circuit board 1 in the aforementioned alternate arrangement. The LED array chips 42a in the lower row are connected to the corresponding driver ICs 44a by bonding wires 5. The LED array chips 42a in the upper row are positioned such that they overlap the corresponding driver ICs 44b in part.

Fig. 14 illustrates the LED array chip 42b in the upper row overlapping the LED array chip 42a in the lower row. Distance W1 is the center-to-center distance between the extreme light emitting element 43aa and its adjacent light emitting elements 43a of the LED array chip 42a. Distance W3 is the center-to-center distance between the extreme light emitting element 43ba and its adjacent light emitting element 43b of the LED array chip 42b. W1 is equal to W3. The distance W2 between the center of the extreme light emitting elements 43aa and the side surface of the LED array chip 42a is selected to be longer than the distance W1/2, so that the distance W4 can be adjusted to the distance W1 or W3 when the LED array chips 42b is held overlapping with the LED array chip 42a. It is to be noted that the LED array chip 42b is held by the driver IC 44b and is not in contact with the LED array chip 42a.

Fig. 15 illustrates the LED array chip 42b in the upper row and the corresponding driver IC 44b. The LED array chip 42b has an electrode pattern 45 on its under side and the electrode pattern 45 is electrically connected via a bump electrode 46 of the driver IC 44b.

The constructions of the lens array, base, and supporting member of the second embodiment may be the same as those of the first embodiment or the modifications of the first embodiment.

Selecting the distance W2 to be somewhat longer than the distance W1/2 allows adjustment of the center-to-center distance W4 between the light-emitting elements 43aa and 43ba to the distance W1. This makes it possible to manufacture LED print heads having a high resolution while still maintaining the same print quality. The arrangement where the LED array chips in two rows are partly overlapping absorbs dimensional variations of the LED array chips to some extent. Therefore, the LED array chips may be scribed in as large a size as possible prior to during dicing process of a wafer, ensuring the manufacture of the LED array chips with high yield.

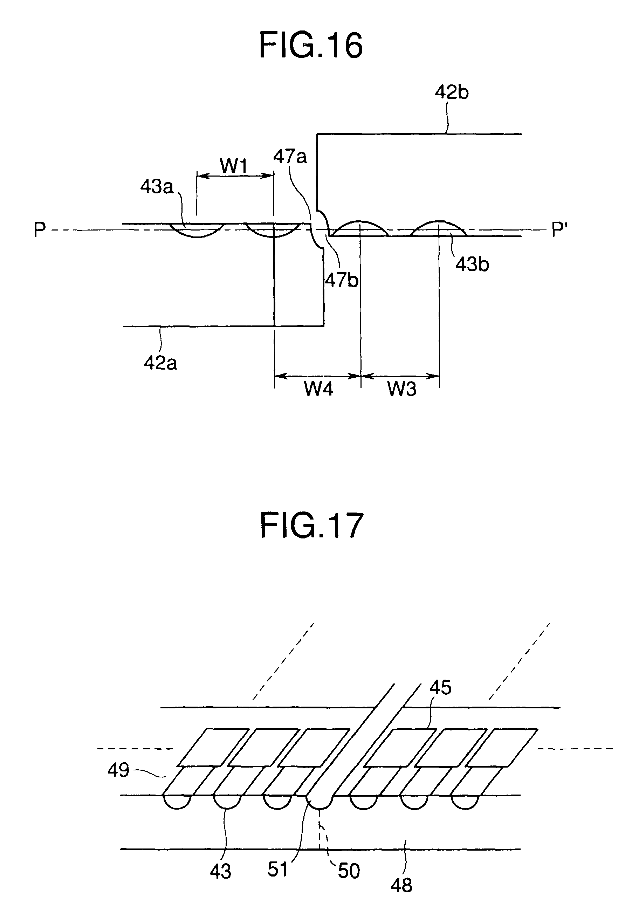

Fig. 16 is a front view of an LED array chip which is a modification of the second embodiment. Fig. 17 is a perspective view of a wafer of the modified LED array chip. Referring to Fig. 16, the upper corner 47a of the LED chip 42a in the lower row is removed by etching. Likewise, the lower corner 47b of the LED chip 42b in the upper row is removed by etching. Removing the corners 47b and 47a of the upper and lower LED array chips 42b and 42a, respectively, allows the upper LED array chip 42b to be positioned at a vertically lower level in the arrangement shown in Fig. 16 than in arrangement shown in Fig. 14, so that the light emitting elements in the upper and lower LED array chips 42b and 42a can be aligned exactly on a single, straight line P-P'.

Fig. 17 shows a wafer 48 of an LED array 49 before it is cut into individual LED array chips 42. The LED array 49 includes light-emitting elements 43 formed in line. The light-emitting elements 43 are to be connected via pads 45 to the driver ICs. Groove 51 are formed to extend perpendicular to a direction of the LED array 49 in which the light-emitting elements 43 are aligned, defining LED chips each of which has a predetermined number of light emitting elements 43. The grooves 51 are formed by etching during the photolithography process in which the light emitting elements 43 of the LED array chip 42 are formed, and can therefore be formed with a high dimensional accuracy. The LED array 49 is cut at the groove 51 to separate into individual LED array chips 42 at the dicing region 50.

The aforementioned modification, further improves the print quality of the optical print head of the second embodiment.

### Third embodiment

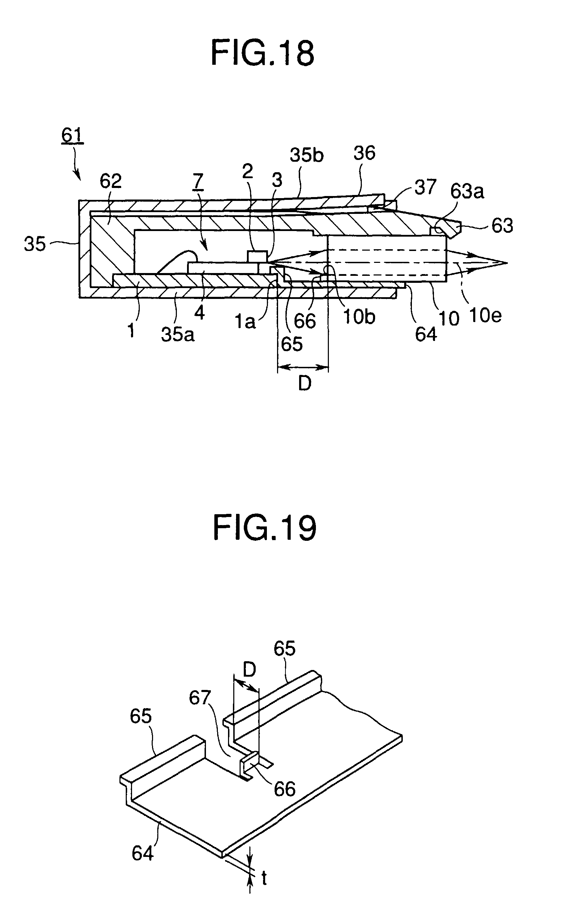

Fig. 18 is a cross-sectional view of an LED print head of a third embodiment. The constructions of a supporting member 62 and a base 35 having a U-shaped cross section are the same as those of the supporting member 39 and the base 35 shown in Fig. 10. The base 35 is made of metal. The supporting member 62 may be made of any suitable material. An upper plate 35b of the base 35 is formed with a spring 36 therein similar to that in Fig. 11A and a projection 37 projecting inwardly of the base 35. The supporting member 62 has an engaging portion 63 at its free end. The engaging portions 63 has a beveled surface 63a downwardly extending toward the tip of the engaging portion 63. The spring 36 urges the engaging portion 63 against the lens array 10 when assembled.

Inserted between the lens array 10 and a lower plate 35a is a positioning member 64. Fig. 19 is a fragmentary perspective view of the positioning member 64. Referring to Fig. 19, the positioning member 64 is formed with a cutout 67 therein and projections 65 of an inverted L-shape at one end of the positioning member 64. Another projection 66 is formed at the end of the cutout 67 and rises in a direction in which the projections 65 rises from the positioning member 64. As shown in Fig. 18, when assembled to the LED print head 61, the L-shaped projections 65 engage a circuit board 1 pressing the side surface 1a and top surface of the circuit board 1 while the projection 66 abuts the side surface 10d of the lens array 10. In other words, the position of the lens array 10 relative to the LED array unit 7 is determined by the distance D between the projections 65 and 66, thereby ensuring that the focal point of the lens array 10 is on the light-emitting elements 3.

The thickness t of the positioning member 64 is selected such that the optical axis 10e of the lens array 10 is at the same height from the lower plate 35a as the light-emitting elements 3 of the LED array chips 2. The projections 65 press the circuit board 1 against the lower plate 35a facilitating the heat transfer from the board 1 to lower plate 35a.

The positioning member 64 is formed by bending a metal sheet having the same thickness as the spacer 26 of the fourth modification of the first embodiment. The positioning member 64 may also be formed, for example, by molding a material such as resin.

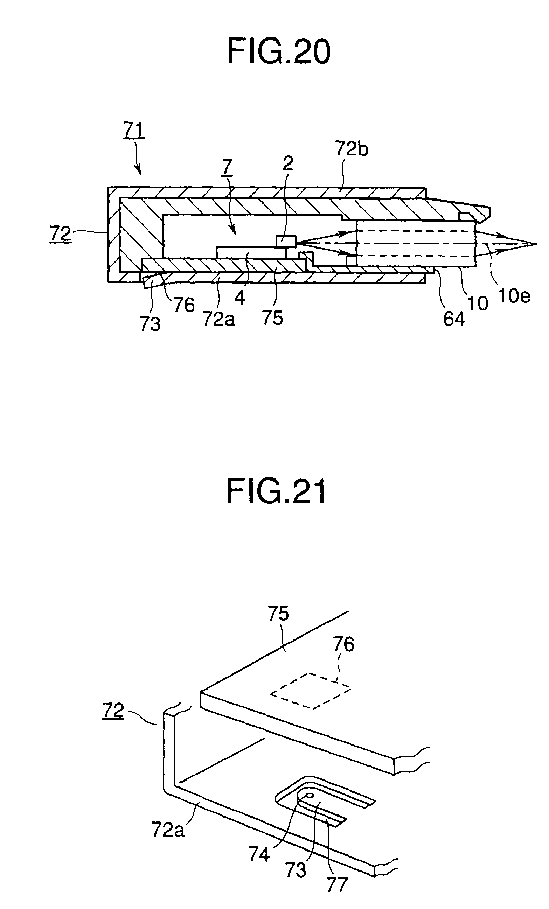

Fig. 20 is a cross-sectional view of an LED print head 71 which is a modification of the third embodiment. Fig. 21 is a perspective view of a relevant part of the LED print head 71. A metal base 72 has a cross section of a generally U-shape and includes an upper plate 72b and a lower plate 72a. The lower plate 72a is formed with a U-shaped holes 77 therein which defines a spring 73. The spring 73 is formed with an inwardly projecting small projection 74 thereon. When the LED print head 71 is assembled, the projection 74 abuts the board 75 of the LED array unit 7 and yieldably flexes outwardly while urging the circuit board 75.

The board 75 has an exposed conductive pattern 76 which electrically contacts with the projection 74 of the spring 73. The rest of the construction of the LED print head 71 is the same as the third embodiment. A plurality of the springs 73 and projections 74 may be formed, as required.

Static electricity resulting from the location of the optical print head close to the photosensitive drum may damage the optical print head. Static electricity may also cause discharge between an operator's body and the optical print head when the operator touches or gets close to the print head during maintenance.

The exposed conductive pattern 76 in contact with the base 72 provides a path of static electricity developed in the base 72 to the ground, thereby preventing the damage of the optical print head.

### Fourth embodiment

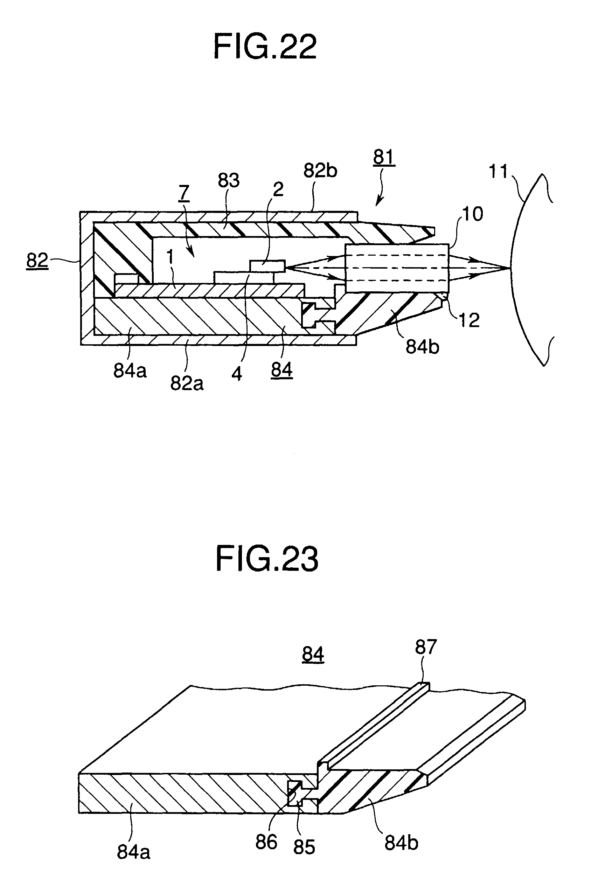

Fig. 22 is a cross-sectional view of an LED print head of a fourth embodiment and Fig. 23 is a fragmentary cross-sectional perspective view of a lower supporting member used in the fourth embodiment.

A metal base 82 having a U-shaped cross section includes upper and lower plates 82b and 82a, which hold an upper supporting member 83 and a lower supporting member 84 in a sandwiched relation. The lower supporting member 84 includes an LED support 84a and a lens support 84b. The upper supporting member 83 engages upper and side surfaces of the circuit board 1 of the LED array unit 7 and cooperates with the LED support 84a to firmly hold the LED array unit 7 therebetween in a sandwiched relation. The upper supporting member 83 engages a lens array 10 and cooperates with the lens support 84b to firmly hold the lens array 10 therebetween in a sandwiched relation.

The LED support 84a is made of, for example, aluminum alloy and has a groove 86 formed therein. The lens support 84b is made by molding a resin and has a projection 85. The projection 85 fits into the groove 86 so that the LED support 84a is firmly connected to the lens support 84b into an integral construction.

The LED support 84a made of aluminum alloy provides efficient heat transfer from the circuit board 1 to the base 82, improving heat dissipation, and provides a higher rigidity preventing the deformation of the lens support 84b.

The lens support 84b is formed with a projection 87 thereon which serves to position the lens array 10 in the direction of its optical axis. The rod lens 10 is bonded to the lens support 84b by an adhesive 12. The lens support 84b is made of a material such as phenol resin, epoxy resin, or unsaturated polyester resin.

The use of resin to form the lens support has the following advantage. The lens support 84b is closer to the photosensitive drum 11 than the LED support 84a when assembled in the electrophotographic printer. The surface of the photosensitive drum 11 is charged and then an electrostatic latent image is formed in the charged surface. If metal is in proximity to the charged surface, then an electric field is developed between the metal and the charged surface of the photosensitive drum 11. Generally, static electricity is detrimental to the print head frame and therefore the metal material of the frame is usually grounded. As a result, the metal construction is always at zero volts so that an electric field is necessarily developed between the print head frame and the photosensitive drum 11. If toner particles are left on the photosensitive drum 11, the toner particles may adhere to the LED print head with the aid of the electric field between the photosensitive drum 11 and the print head frame. The toner particles adhering to the LED print head interfere with the light which illuminates the photosensitive drum 11 during printing operation, leading to poor print quality. Therefore, forming the lens support 84b of resin rather than metal, effectively prevents deterioration of print quality.

The LED support 84a and lens support 84b are made of materials having substantially the same coefficient of thermal expansion. The substantially the same coefficient of thermal expansion prevents deformation of the overall construction of the lower supporting member 84 which is encountered if the LED support 84a and lens support 84b have considerably different coefficients of thermal expansion.

## Claims

1. An optical print head, comprising:
a light-emitting array chip (2) having light emitting elements (43);
a driver IC (4) electrically driving said light-emitting array chip (2) to emit light;
a lens array (10) having a focal point, said lens array (10) gathering the light emitted from said light-emitting elements (43) and emanating the gathered light, said lens array (10) being positioned relative to said light-emitting array chip (2) so that the focal point of said lens array (10) is on the light-emitting elements (43); and
a circuit board (1, 75) having a surface to which said light-emitting array chip (2) and said driver IC (4) are mounted, said circuit board (1, 75) supporting said light-emitting array chip (2) so that said light-emitting elements (43) emit the light in a first direction parallel to the surface of said circuit board (1, 75).

2. The optical print head according to Claim 1, wherein there are provided a plurality of said light-emitting array chips (2) and a plurality of said driver ICs, said plurality of light-emitting array chips (2) being aligned straight in a second direction perpendicular to the first direction and parallel to the surface of said circuit board.

3. The optical print head according to Claim 2, wherein said light-emitting array chips (2) are mounted on said driver ICs, each light-emitting array chip (2) being electrically and mechanically connected to the corresponding driver IC.

4. The optical print head according to Claim 2, wherein said light-emitting array chips (2) are positioned relative to a front edge of said circuit board such that the focal point of said lens array (10) is on the light-emitting elements (43) when the front edge of said circuit board is positioned to abut said lens array.

5. The optical print head according to Claim 2 further including a reference member (24, 28, 35, 72), wherein said light-emitting array chips (2) and said lens array (10) are positioned relative to said reference member in a third direction normal to the surface of said circuit board.

6. The optical print head according to Claim 5 further including a spacer (26) inserted between said reference member (24, 28, 35, 72) and said lens array (10) so as to adjust the position of the optical axis of said lens array (10) in said third direction.

7. The optical print head according to Claim 5, wherein said reference member (28, 35, 72) has a first plate (28a, 35a, 72a) and a second plate (28b, 35b, 72b) opposing each other, and said circuit board (1) and said lens array (10) are sandwiched between said first and second plates, said light-emitting array chips (2) and said lens array (10) being positioned relative to said first plate.

8. The optical print head according to Claim 7, wherein said reference member has a spring which urges said lens array so as to firmly hold said lens array (10) between said first and second plates.

9. The optical print head according to Claim 2 further including a positioning member (64), wherein said positioning member (64) positions said lens array (10) relative to said light-emitting elements (43) in the third direction.

10. The optical print head according to Claim 9, wherein said circuit board (75) has a conductive pattern (76) formed thereon, and said reference member is connected to ground and has an electrical contact (74) in contact with the conductive pattern (76).

11. The optical print head according to Claim 2 further including a supporting member (84) having a first support (84a) made of a metal and a second support (84b) made of a resin, said first support (84a) supporting said circuit board (1) and said second support (84b) supporting said lens array (10).

12. The optical print head according to Claim 11, wherein said first support (84a) is secured to said second support (84b), said first and second supports (84a, 84b) having a substantially same coefficient of thermal expansion.

13. The optical print head according to Claim 1, wherein there are provided a plurality of said light-emitting array chips, each of said light-emitting array chips having a side surface with a center line extending parallel to the second direction, said light emitting elements being offset from the center line, wherein said light emitting array chips are arranged in an upper row and in a lower row, the chips in the lower row being mounted face up and the chips in the upper row being mounted face down, the chips in the upper row overlapping with adjacent chips in the lower row such that the light-emitting elements are equally spaced in the second direction.

14. The optical print head according to Claim 13, wherein said light-emitting array chips have corner portions cut away and said light-emitting array chips in the upper row are positioned relative to said light-emitting array chips in the lower row such that the light-emitting elements are in a single line extending in the second direction.

## Patentansprüche

1. Optischer Druckkopf umfassend:
einen licht-emittierenden Matrixchip (2), der licht-emittierende Elemente (43) aufweist; einen Treiber IC (4), der den licht-emittierenden Matrixchip (2) antreibt, so dass er Licht emittiert;
eine Linsenmatrix (10) mit einem Brennpunkt, wobei die Linsenmatrix (10) das von den licht-emittierenden Elementen (43) abgegebene Licht sammelt und das gesammelte Licht abgibt, wobei die Linsenmatrix (10) in Bezug auf den licht-emittierenden Matrixchip (2) so positioniert ist, daß der Brennpunkt der Linsenmatrix (10) auf den licht-emittierenden Elementen (43) liegt; und
eine Schaltungsplatine (1, 75), die eine Oberfläche hat, auf der der licht-emittierende Matrixchip (2) und der Treiber IC (4) montiert sind, wobei die Schaltungsplatine (1, 75) den licht-emittierenden Matrixchip (2) so trägt, dass die licht-emittierenden Elemente (43) das Licht in einer ersten Richtung parallel zu der Oberfläche der Schaltungsplatine (1, 75) abstrahlen.

2. Optischer Druckkopf nach Anspruch 1, worin eine Vielzahl der licht-emittierenden Matrixchips (2) und eine Vielzahl der Treiber IC's vorgesehen sind, wobei die Vielzahl der licht-emittierenden Matrixchips (2) geradlinig in einer zweiten Richtung senkrecht zu der ersten Richtung und.parallel zu der Oberfläche der Schaltungsplatine ausgerichtet sind.

3. Optischer Druckkopf nach Anspruch 2, worin die licht-emittierenden Matrixchips (2) auf dem Treiber IC montiert sind, wobei jeder licht-emittierende Matrixchip (2) elektrisch und mechanisch mit dem entsprechenden Treiber IC verbunden ist.

4. Optischer Druckkopf nach Anspruch 2, worin die licht-emittierenden Matrixchips (2) in Bezug auf die Vorderkante der Schaltungsplatine so angeordnet sind, dass der Brennpunkt der Linsenmatrix (10) sich auf den licht-emittierenden Elementen (43) befindet, wenn die Vorderkante der Schaltungsplatine so angeordnet ist, dass sie an der Linsenmatrix anschlägt.

5. Optischer Druckkopf nach Anspruch 2, ferner umfassend einen Referenzteil (24, 28, 35, 72), worin die licht-emittierenden Matrixchips (2) und die Linsenmatrix (10) in Bezug auf den Referenzteil in einer dritten Richtung, die senkrecht zu der Oberfläche der Schaltungsplatine ist, positioniert sind.

6. Optischer Druckkopf nach Anspruch 5, ferner umfassend einen Abstandsteil (26), der zwischen dem Bezugsteil (24, 28, 35, 72) und der Linsenmatrix (10) eingesetzt ist, um die Position der optischen Achse der Linsenmatrix (10) in der dritten Richtung einzujustieren.

7. Optischer Druckkopf nach Anspruch 5, worin der Referenzteil (28, 35, 72) eine erste Platte (28a, 35a, 72a) und eine zweite Platte (28b, 35b, 72b) aufweist, die einander gegenüberliegen, wobei die Schaltungsplatine (1) und die Linsenmatrix (10) sandwichartig zwischen den ersten und zweiten Platten angeordnet sind, und wobei die licht-emittierenden Matrixchips (2) und die Linsenmatrix (10) relativ zu der ersten Platte positioniert sind.

8. Optischer Druckkopf nach Anspruch 7, worin der Referenzteil eine Feder aufweist, die die Linsenmatrix so vorspannt, dass die Linsenmatrix (10) zwischen der ersten und zweiten Platte festgehalten wird.

9. Optischer Druckkopf nach Anspruch 2, ferner umfassend einen Positionierungsteil (64), worin der Positionierungsteil (64) die Linsenmatrix (10) relativ zu den licht-emittierenden Elementen (43) in der dritten Richtung positioniert.

10. Optischer Druckkopf nach Anspruch 9, worin die Schaltungsplatine (75) ein Leitermuster (76) aufweist, das darauf ausgebildet ist, und worin der Referenzteil mit Erde verbunden ist und einen elektischen Kontakt (74) aufweist, der in Kontakt mit dem Leitermuster (76) ist.

11. Optischer Druckkopf nach Anspruch 2, ferner umfassend einen Trageteil (84), der einen ersten Träger (84a), der aus einem Metall hergestellt istund einen zweiten Träger (84b), der aus einem Kunstharz hergestellt ist, aufweist, wobei der erste Träger (84a) die Schaltungsplatine (1) und der zweite Träger (84b) die Linsenmatrix (10) trägt.

12. Optischer Druckkopf nach Anspruch 11, worin der erste Träger (84a) an dem zweiten Träger (84b) befestigt ist, wobei die ersten und zweiten Träger (84a, 84b) im wesentlichen den gleichen thermischen Ausdehnungskoeffizienten haben.

13. Optischer Druckkopf nach Anspruch 1, worin eine Vielzahl der licht-emittierenden Matrixchips vorgesehen ist, wobei jeder der licht-emittierenden Matrixchips eine Seitenfläche hat, deren Mittellinie sich parallel zu der zweiten Richtung erstreckt, die licht-emittierenden Elemente zu der Mittellinie versetzt sind, wobei die licht-emittierenden Matrixchips in einer oberen Reihe und einer unteren Reihe angeordnet sind, wobei die Chips in der unteren Reihe mit dem Gesicht nach oben und die Chips in der oberen Reihe mit dem Gesicht nach unten montiert sind, und wobei die Chips in der oberen Reihe sich mit danebenliegenden Chips in der unteren Reihe überlappen, so dass die licht-emittierenden Elemente in der zweiten Richtung unter gleichen Abständen angeordnet sind.

14. Optischer Druckkopf nach Anspruch 13, worin die licht-emittierenden Matrixchips Eckenbereiche haben, die weggeschnitten sind, und wobei die licht-emittierenden Matrixchips in der oberen Reihe relativ zu den licht-emittierenden Matrixchips in der unteren Reihe so angeordnet sind, dass die licht-emittierenden Elemente in einer einzigen Linie liegen, die sich in der zweiten Richtung erstreckt.

## Revendications

1. Tête d'impression optique, comprenant:
- une microplaquette à matrice électroluminescente (2) comportant des éléments électroluminescents (43),
- un circuit intégré pilote (4) commandant électriquement la dite microplaquette à matrice électroluminescente (2) pour émettre de la lumière,
- un groupe / ensemble de lentilles (10) présentant un foyer, ledit ensemble de lentilles (10) captant la lumière émise par lesdits éléments électroluminescents (43) et émettant la lumière captée, ledit ensemble de lentilles (10) étant positionné relativement à la dite microplaquette à matrice électroluminescente (2) de manière que le foyer de l'ensemble de lentilles (10) se trouve sur les éléments électroluminescents (43), et
- une carte de circuits (1, 75) présentant une surface sur laquelle la microplaquette à matrice électroluminescente (2) et le circuit intégré pilote (4) sont montés, cette carte de circuits (1, 75) supportant la microplaquette à matrice électroluminescente (2) de manière que les éléments électroluminescents (43) émettent la lumière selon une première direction parallèle par rapport à la surface de ladite carte de circuits.

2. Tête d'impression optique selon la revendication 1, dans laquelle est prévue une pluralité desdites microplaquettes à matrice électroluminescente (2) et une pluralité desdits circuits intégrés pilote, lesdites plusieures microplaquettes à matrice électroluminescente (2) étant alignées sur une droite selon une deuxième direction perpendiculaire à la première direction et parallèle par rapport à la surface de ladite carte de circuits.

3. Tête d'impression optique selon la revendication 2, dans laquelle lesdites microplaquettes à matrice électroluminescente (2) sont montées sur lesdits circuits intégrés pilote, chacune des microplaquettes à matrice électroluminescente (2) étant connectée électriquement et mécaniquement au circuit intégré pilote correspondant.

4. Tête d'impression optique selon la revendication 2, dans laquelle les microplaquettes à matrice électroluminescente (2) sont positionné relativement à un bord frontal de cette carte de circuits de manière que le foyer de l'ensemble de lentilles (10) se trouve sur les éléments électroluminescents (43) quand le bord frontal de cette carte de circuits est porté en appui contre cet ensemble de lentilles (10).

5. Tête d'impression optique selon la revendication 2, comprenant en outre un membre de référence (24, 28, 35, 72), les microplaquettes à matrice électroluminescente (2) et l'ensemble de lentilles (10) étant positionnés relativement à ce membre de référence dans une troisième direction normale par rapport à la surface de ladite carte de circuits.

6. Tête d'impression optique selon la revendication 5, comprenant en outre un écarteur (26) inséré entre le membre de référence (24, 28, 35, 72) et l'ensemble de lentilles (10) de façon à ajuster la position de l'axe optique de l'ensemble de lentilles (10) dans cette troisième direction.

7. Tête d'impression optique selon la revendication 5, dans laquelle le membre de référence (28, 35, 72) présente une première plaque (28a, 35a, 72a) et une deuxième plaque (28b, 35b, 72b) opposées l'une par rapport à l'autre, et ladite carte de circuits (1) et l'ensemble de lentilles (10) sont disposés de façon ,,sandwich" entre ces première et deuxième plaques, les microplaquettes à matrice électroluminescente (2) et l'ensemble de lentilles (10) étant positionnés relativement à cette première plaque.

8. Tête d'impression optique selon la revendication 7, dans laquelle ledit membre de référence comporte un ressort chargeant cet ensemble de lentilles de façon à retenir fermement cet ensemble de lentilles (10) entre ces première et deuxième plaques.

9. Tête d'impression optique selon la revendication 2, comprenant en outre un membre de positionnement (64), ce membre de positionnement (64) positionnant l'ensemble de lentilles (10) relativement aux éléments électroluminescents (43) dans la troisième direction.

10. Tête d'impression optique selon la revendication 9, dans laquelle la carte de circuits (75) présente un système de circuits imprimés (76) formé sur celle-ci, et ledit membre de référence est connecté à la terre et comporte un contact électrique (74) qui est connecté au système de circuits imprimés (76).

11. Tête d'impression optique selon la revendication 2, comprenant en outre un membre de support (84) présentant un premier support (84a) réalisé en métal et un deuxième support (84b) réalisé en un résin, ce premier support (84a) supportant la carte de circuits (1) et ce deuxième support (84b) supportant l'ensemble de lentilles (10).

12. Tête d'impression optique selon la revendication 11, dans laquelle le premier support (84a) est fermement fixé au deuxième support (84b), ces premier et deuxième supports (84a, 84b) présentant essentiellement le même coefficient de dilatation thermique.

13. Tête d'impression optique selon la revendication 1, dans laquelle est prévue une pluralité desdites microplaquettes à matrice électroluminescente, chacune de ces microplaquettes à matrice électroluminescente présentant une surface latérale avec une ligne de milieu s'étendant parallèlement à la deuxième direction, lesdits éléments électroluminescents étant décalés par rapport à la ligne de milieu, lesdites microplaquettes à matrice électroluminescente étant disposées de manière à constituer une rangée supérieure et une rangée inférieure, les microplaquettes de la rangée inférieure étant installées avec la face orientée vers le haut, les microplaquettes de la rangée supérieure étant installées avec la face orientée vers le bas, les microplaquettes de la rangée supérieure étant disposées en chevauchement avec les microplaquettes adjacentes de la rangée inférieure de façon que les éléments électroluminescents soient écartés régulièrement dans la deuxième direction.

14. Tête d'impression optique selon la revendication 13, dans laquelle lesdites microplaquettes à matrice électroluminescente présentent des portions de coins découpées, et les microplaquettes de la rangée supérieure sont positionnées relativement aux microplaquettes de la rangée inférieure de façon que les éléments électroluminescents se trouvent dans une seule ligne s'étendant dans la deuxième direction.
